Europäisches Patentamt

European Patent Office

Office européen des brevets

(11) Publication number: **0 170 781**
**B1**

## (12) EUROPEAN PATENT SPECIFICATION

(45) Date of publication of patent specification: **17.10.90**

(51) Int. Cl.⁵: **G 11 C 11/24**

(21) Application number: **85104364.6**

(22) Date of filing: **12.03.82**

(60) Publication number of the earlier application in accordance with Art. 76 EPC: **0 061 271**

(54) MOS dynamic memory device.

(30) Priority: **13.03.81 JP 36945/81**

(43) Date of publication of application:
**12.02.86 Bulletin 86/07**

(45) Publication of the grant of the patent:
**17.10.90 Bulletin 90/42**

(84) Designated Contracting States:
**DE FR GB NL**

(56) References cited:
**WO-A-80/01972**

**PATENT ABSTRACTS OF JAPAN, vol. 4, no. 58
(P-9)540r, 30th April 1980 & JP-A-55-28 542**

(73) Proprietor: **FUJITSU LIMITED
1015, Kamikodanaka Nakahara-ku
Kawasaki-shi Kanagawa 211 (JP)**

(72) Inventor: **Takemae, Yoshihiro
1-20-5-9-301, Utsukushigaoka Midori-ku
Yokohama-shi Kanagawa 227 (JP)**
Inventor: **Nakano, Tomio
1-11-2-12-404, Shirahatadai Takatsu-ku
Kawasaki-shi Kanagawa 213 (JP)**
Inventor: **Ohira, Tsuyoshi
Fujitsu Dai 2 Eda-ryo 440-1, Eda-cho Midori-ku
Yokohama-shi Kanagawa 226 (JP)**

(74) Representative: **Rackham, Stephen Neil et al
GILL JENNINGS & EVERY 53-64 Chancery Lane
London WC2A 1HN (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to a semiconductor memory device, and particularly to an MOS dynamic memory device having an output circuit with increased output level.

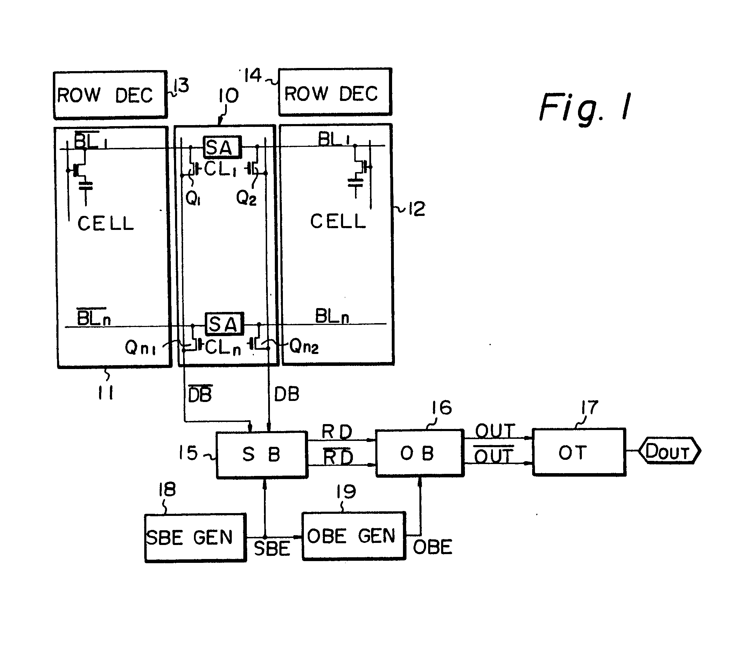

As shown in Fig. 1 of the accompanying drawings, an MOS dynamic memory device generally comprises sense ampifier circuits SA and a group of column decoders 10 arranged in the centre of a semiconductor substrate (chip), as well as a group of memory cells 11, 12 and a group of row decoders 13, 14 arranged at each side of the semiconductor substrate. In the memory device, a sense buffer circuit 15 is connected to a pair of data buses DB, $\overline{DB}$ leading from the group of column decoders 10, and a data output $D_{out}$ is obtained by a system comprising the sense buffer circuit 15, an output buffer circuit 16, and a group of output transistors 17. The column decoders 10 produce output signals $CL_1$ to $CL_n$. Gate transistors $Q_1$-$Q_{n2}$ are turned on and off by the output signals $CL_1$ to $CL_n$. Bit lines $\overline{BL_1}$ to $BL_n$ are connected to the sense amplifiers SA. An SBE (sense buffer enable) signal generator 18 and an OBE (output buffer enable) signal generator 19 provide SBE and OBE signals for actuating, respectively, the sense buffer circuit 15 and the output buffer circuit 16.

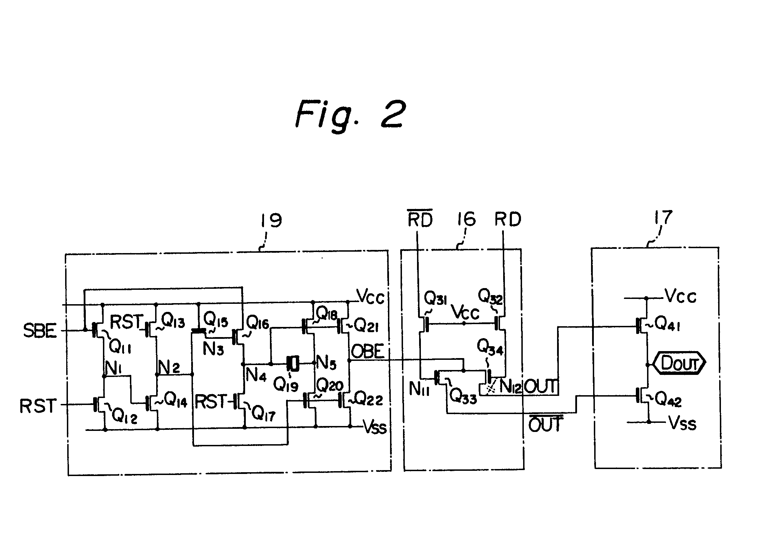

The OBE generator 19, the output buffer circuit 16, and the group of output transistors 17 of the device of Fig. 1 are illustrated in detail in Fig. 2. As shown in Fig. 2, the OBE generator 19 consists of MOS transistors $Q_{11}$ to $Q_{22}$; the output buffer circuit 16 consists of MOS transistors $Q_{31}$ to $Q_{34}$, and the group of output transistors 17 consists of MOS transistors $Q_{41}$ and $Q_{42}$. The transistors $Q_{11}$ to $Q_{22}$, $Q_{31}$ to $Q_{34}$, and $Q_{41}$ and $Q_{42}$ are connected between voltage sources $V_{CC}$ and $V_{SS}$. The transistors are interconnected at nodes N1 to N5, N11 and N12. RST indicates a reset signal.

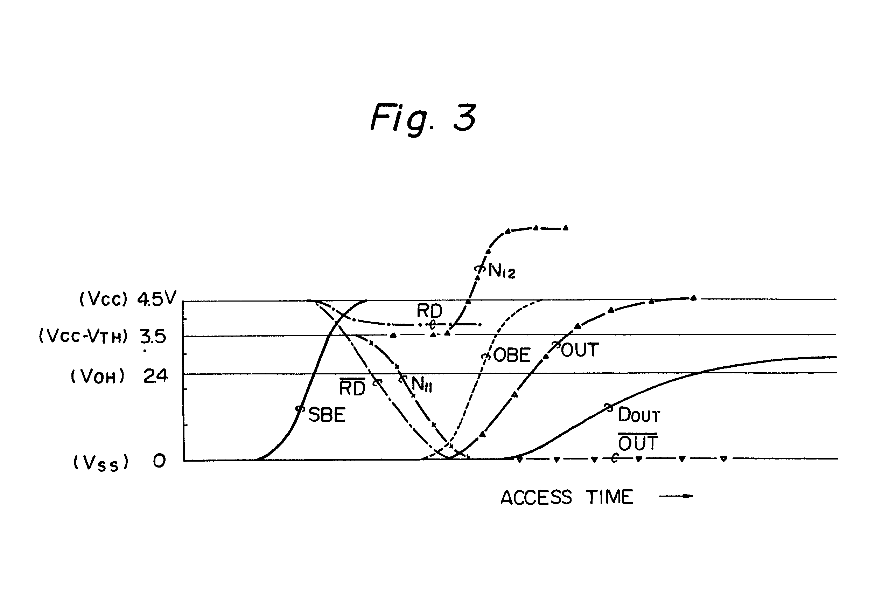

The operation of the circuit in Fig. 2 will be described with reference to Fig. 3, in which various wave forms of the voltages of signals appearing in the circuit are illustrated.

At first, when the SBE signal from the signal generator 18 rises, the sense buffer circuit 15 is actuated and starts to operate to turn one of its outputs RD and $\overline{RD}$ to the "H" level and the other output to the "L" level in accordance with the read-out data from the data buses DB and $\overline{DB}$. In the case shown in Fig. 3, it turns the output RD to the "H" level and the output $\overline{RD}$ to the "L" level. The output buffer circuit 16 receives the signals OBE, RD and RD, and in the circuit 16, in response to the signal RD, the transistor $Q_{34}$ is turned ON and the transistor $Q_{33}$ is turned OFF. Therefore, one output OUT rises in accordance with the rising of the signal OBE and the other output $\overline{OUT}$ remains at the "L" level.

In the group of output transistors 17 receiving the output signals OUT and $\overline{OUT}$, the transistor $Q_{41}$ is turned ON, the transistor $Q_{42}$ is turend OFF, and, accordingly, the output signal $D_{out}$ is turned to the "H" level.

In the above-mentioned memory device, the "H" level of the output signal OBE from the signal generator is almost equal to the level of the voltage source $V_{CC}$ due to the bootstrap effect produced by an MOS capacitor $Q_{19}$. Accordingly, even though this "H" level of the output signal OBE may be transmitted directly to the output signal OUT or $\overline{OUT}$ of the output buffer circuit 16 by means of the bootstrap effect of the gate capacitance of the transistor $Q_{33}$ or $Q_{34}$, the maximum level of the signals OUT, $\overline{OUT}$ is that of the voltage source $V_{CC}$. Therefore the level of the final output signal $D_{out}$ becomes less than the voltage source $V_{CC}$, at least by the threshold level $V_{TH}$ of the transistor $Q_{41}$. Although it is necessary that the "H" level $V_{OH}$ of the final output $D_{out}$ be higher than 2.4 volts under the condition that the load current of a predetermined value is flowing, it may be difficult to fulfil the above-mentioned requirement in any case in accordance with the circuit of Fig. 2. For example, assuming that the voltage source $V_{CC}=4.5V$ and the threshold level of the transistor Q41 is $V_{TH}=1.0$, the maximum level of the output $D_{out}$ is less than $9V_{CC}-V_{TH}=3.5V$, and, when the load current increases, the level of the output $D_{out}$ decreases, so that it may be less than 2.4V. In such a case, the rise time of the output $D_{out}$ is slow, as shown in Fig. 3, and, accordingly, the access time of the memory device increases.

An object of the present invention is to overcome the above-mentioned disadvantage of the prior art memory device, and to provide a semiconductor memory device in which the level of the output buffer enable signal OBE is increased.

According to the present invention a semiconductor memory device comprising a higher voltage supply; a lower voltage supply; and a signal generator circuit for delivering a signal which is higher than the higher supply voltage in response to an input signal; is characterised in that a voltage generator circuit supplies an output voltage which is higher than the higher supply voltage as a power supply voltage to the signal generator circuit; in that the output stage of the signal generator circuit has a first transistor which is connected to the lower voltage supply and a second transistor which is connected to the output voltage of the voltage generator circuit, the first and second transistors being connected in a push-pull configuration with a junction between them being connected to the output terminal of said signal generator circuit; and in that an output portion of the voltage generator circuit has a push-up capacitor which is connected thorugh one of its electrodes to the output terminal and is operable to push up the output voltage to a potential higher than the higher voltage supply voltage, a charging transistor which is turned ON prior to the rise in potential of the output terminal of the signal generator circuit to charge the push-up capacitor via the higher supply voltage and is turned OFF to cut the push-up capacitor from the higher supply voltage when the potential of the output terminal of the signal generator circuit is raised, and a transistor as a clock means which supplies a clock signal of the same polarity as the higher voltage supply to the other electrode of the push-up capacitor in response to an input signal to raise the potential of the output terminal of the signal generator circuit.

An embodiment of the present invention will now be described, by way of example, with reference to the accompanying drawings, in which:

Fig. 1 is a block diagram of a prior art MOS dynamic memory device as described above,

Fig. 2 is a detailed circuit diagram of an OBE signal generator circuit, an output buffer circuit, and a group of output transistors in the device of Fig. 1,

Fig. 3 illustrates various voltage waveforms appearing in the circuit of Fig. 2,

Fig. 4 is a block diagram of a semiconductor memory device in accordance with the present invention,

Fig. 5 illustrates various voltage waveforms for explaining the operation of the device of Fig. 4,

Fig. 6 is a detailed circuit diagram of an OBE signal generator circuit and a $V_{BS}$ voltage generator circuit in the device of Fig. 4, and

Fig. 7 illustrates various voltage waveforms appearing in the circuit of Fig. 6.

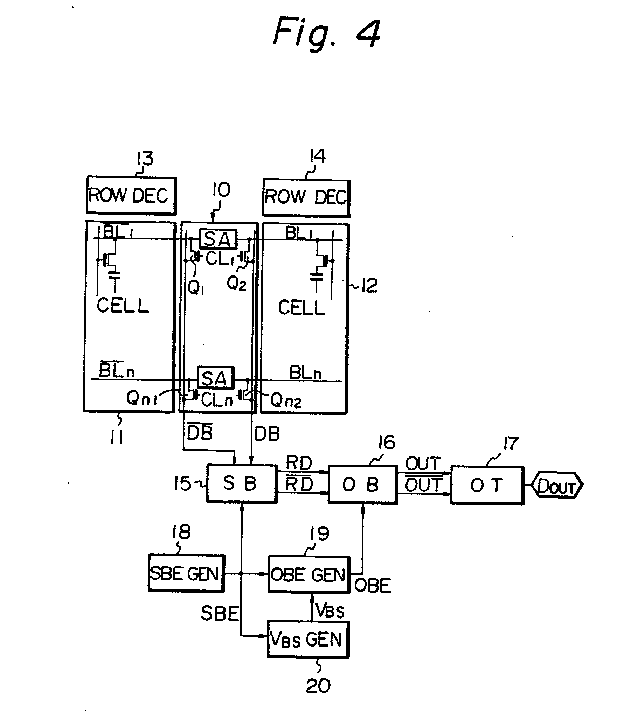

An MOS dynamic memory device according to the present invention is illustrated in Fig. 4 of the drawings. The memory device of Fig. 4 has the same construction as the device of Fig. 1 described above, except that it further comprises a $V_{BS}$ voltage generator circuit 20 for generating a voltage signal $V_{BS}$ higher than the supply voltage $V_{CC}$, the voltage signal $V_{BS}$ being used as a voltage supply to the output stage of the OBE signal generator circuit 19 instead of the voltage $V_{CC}$.

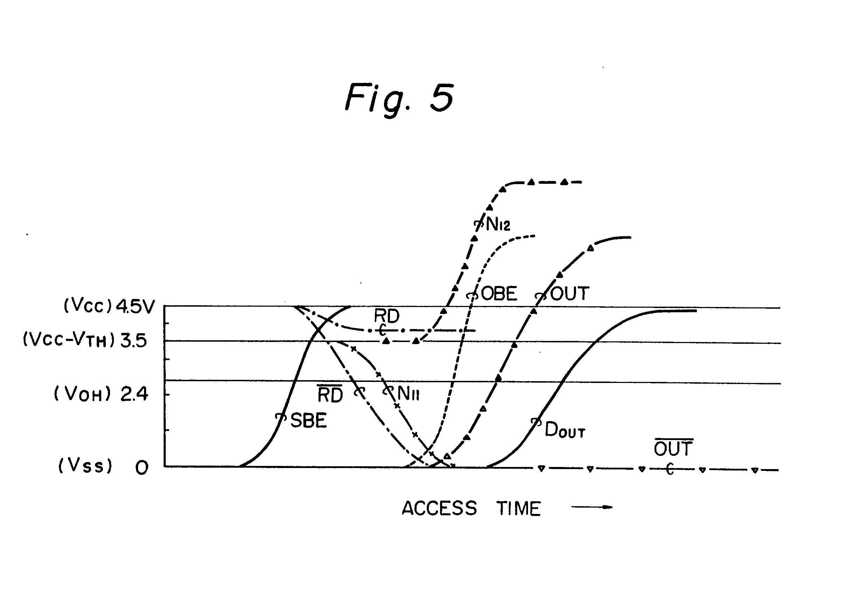

Various voltage waveforms in the device of Fig. 4 are illustrated in Fig. 5 to explain the operation of the memory device according to the present invention. As shown in Fig. 5, in the latter device the signal OBE rises rapidly to a level higher than the supply voltage $V_{CC}$. Accordingly, the output OUT of the buffer circuit 16 also rises above the supply voltage $V_{CC}$, and therefore the final output $D_{out}$ rises rapidly almost to the level of the supply voltage $V_{CC}$. Hence, the output signal $D_{out}$ becomes sufficiently higher than the required "H" output level $V_{OH}=2.4V$, and the access time of the memory device becomes shorter due to the decrease in rise time.

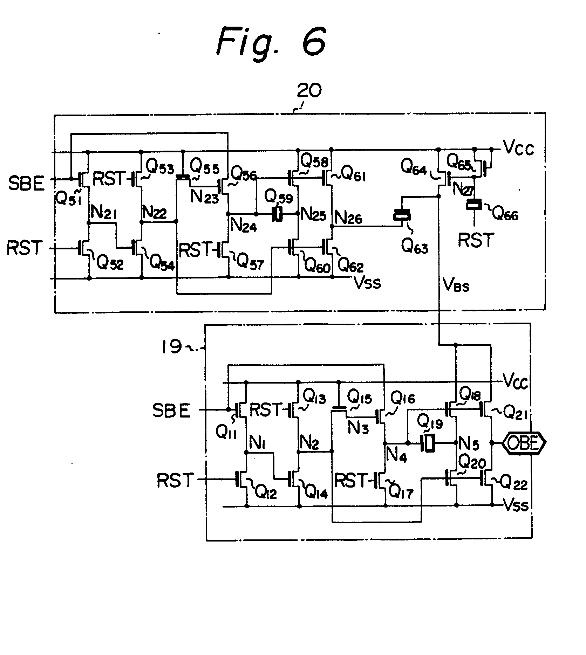

A detailed circuit daigram of the OBE signal generator circuit 19 and a $V_{BS}$ voltage generator circuit 20, by which circuits the above-mentioned operation of the memory device is realised, is illustrated in Fig. 6. The OBE signal generator circuit 19 of Fig. 6 has the same construction as that of Fig. 2, except that the output stage transistors $Q_{18}$ and $Q_{21}$ of Fig. 6 are connected to a $V_{BS}$ output of the voltage generator circuit 20 instead of to the supply voltage $V_{CC}$, which voltage $V_{BS}$ rises higher than the supply voltage $V_{CC}$. The voltage generator circuit 20 consists of MOS

transistors $Q_{51}$ to $Q_{66}$ which are interconnected between the supply voltages $V_{CC}$ and $V_{SS}$ as shown in Fig. 6. The transistors are interconnected at nodes N21 to N27.

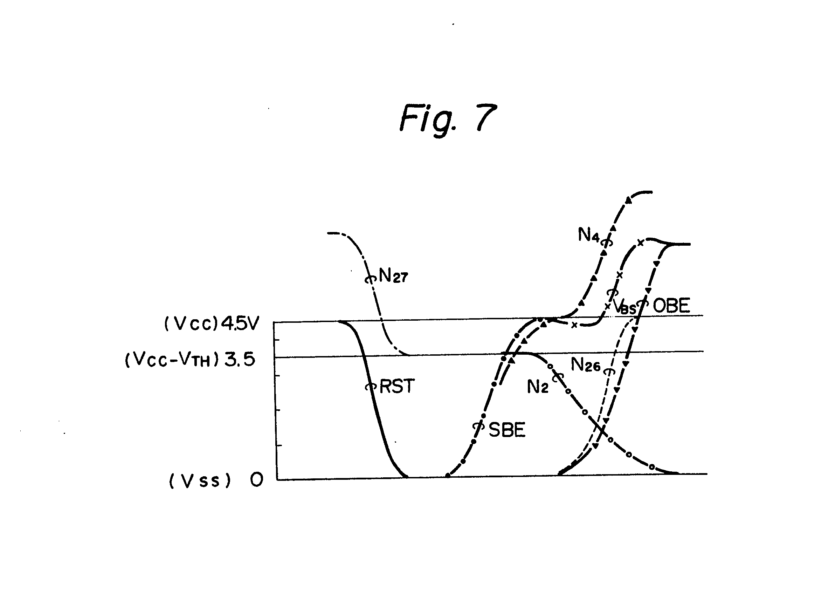

The operation of the circuit of Fig. 6 will now be described with reference to the various voltage waveforms in Fig. 7. At first, a reset signal RST, which is one of the input signals to the voltage generator circuit 20, remains at the "H" level, and the signal SBE, which is another input to the circuit 20, remains at the "L" level. Thus, the transistor $Q_{52}$ is kept ON, the transistor $Q_{51}$ is kept OFF, the node N21 is kept at the "L" level, the transistor $Q_{54}$ is kept OFF and the transistor $Q_{53}$ is kept ON. Therefore, the nodes N22 and N23 remain at the "H" level (accordingly, the gate capacitance of the transistor $Q_{56}$ is charged up), and the transistors $Q_{60}$ and $Q_{62}$ are kept ON. In addition, the node N24 remains at the "L" level, and therefore the transistors $Q_{58}$ and $Q_{61}$ are kept OFF and the nodes N25 and N26 remain at the "L" level. Furthermore, the node N27 remains at an "HH" level, higher than the normal "H" level, due to the push-up effect produced by the MOS capacitor $Q_{66}$ and the signal RST, so that the transistor $Q_{64}$ is kept fully ON. Therefore, the MOS capacitor $Q_{63}$ is charged up to the level of the supply voltage $V_{CC}$. Thus, at this stage, the output voltage $V_{BS}$ of the voltage generator circuit 20 is kept at the $V_{CC}$ level.

In the above-mentioned condition, when the signal RST falls, the potential of the node N27 falls to a level lower than the $V_{CC}$ level by the threshold voltage $V_{TH}$ of the transistor $Q_{65}$, and the MOS capacitor $Q_{66}$ is charged up to this potential $(V_{CC}-V_{TH})$, so that any charge lost in the capacitor $Q_{66}$, while the push-up effect is being carried out, is compensated for. In addition the output voltage $V_{BS}$, which has been kept at the $V_{CC}$ level, becomes disconnected from the $V_{CC}$ supply because the transistor $Q_{64}$ is turned OFF. This falling of the signal RST is effected before the rising of the signal SBE. When the signal SBE rises after the falling of the signal RST, the transistor $Q_{51}$ is turned ON, $Q_{52}$ is kept OFF, the node N21 is switched to the "H" level, the transistor $Q_{54}$ is turned ON, the transistor $Q_{53}$ is kept OFF, the node N22 is switched to the "L" level, the transistors $Q_{55}$, $Q_{60}$, $Q_{62}$ are turned OFF, and the transistor $Q_{57}$ is kept OFF. Therefore the node N24, which receives the signal SBE through the transistor $Q_{56}$ being turned ON, is set to the "H" level, the transistors $Q_{58}$ and $Q_{61}$ are turned ON, and the nodes N25 and N26 are switched to the "H" level. Since the MOS capacitor $Q_{63}$ is charged up to the supply voltage $V_{CC}$ as described above, the output voltage $V_{BS}$ is pushed up above the supply voltage $V_{CC}$, as shown in Fig. 7, when the node N26 rises up to the level of $V_{CC}$ due to the bootstrap effect of the MOS capacitor $Q_{59}$.

In the OBE signal generator circuit 19, when the signal SBE rises the transistor $Q_{11}$ is turned ON, the transistor $Q_{12}$ is turned OFF, the node N1 is set to the "H" level, the transistor $Q_{14}$ is turned ON, and the transistor $Q_{13}$ is turned OFF, and, accordingly, the node N2 falls to the "L" level. Thus, the transistors $Q_{20}$ and $Q_{22}$ are turned OFF. At the period between the signal SBE rising and the node N3 being charged, the transistor $Q_{16}$ is kept ON and the transistor $Q_{17}$ is turned OFF. Accordingly, the node N4 rises together with the signal SBE. Hence, the transistors $Q_{18}$ and $Q_{21}$ are turned ON and are more fully turned ON due to the bootstrap effect provided by the MOS capacitor $Q_{19}$. Therefore, the levels of the node N5 and the output OBE rise rapidly above the supply voltage $V_{cc}$ following the output voltage $V_{BS}$ which is pushed up to the "HH" level, as shown in Fig. 7. By obtaining the above-mentioned signal OBE, the output voltage OUT of the output buffer circuit 16, which has the same construction as that of Fig. 2, attains an "HH" level almost equal to that of the signal OBE because the transistor $Q_{34}$ is kept ON by its gate capacity; then the output transistor $Q_{41}$ is fully turned ON and the output $D_{out}$ is turned to an "H" level almost equal to the $V_{cc}$ level.

As a way of raising the output voltage to a level almost equal to the supply voltage $V_{cc}$, a bootstrap circuit similar to the circuit using the capacitors $Q_{19}$ and $Q_{59}$ shown in Fig. 2 or Fig. 6 may be utilised. However, such an arrangement is not suitable for spending up the rise of the output signal $D_{out}$. That is, in such an arrangement, the MOS capacitors $Q_{19}$ and $Q_{59}$ are first charged up at the arrival of the signal SBE. Then the levels of the nodes N5 and N25 are raised so that the bootstrap effect is put into action, and the final output voltage rises to the level of the supply voltage $V_{cc}$. Therefore, the time required for the output voltage to reach the supply voltage $V_{cc}$ is relatively long. Hence, since the access time of the memory device is long, the above-mentioned arrangement does not fulfil the object of the present invention.

In the circuit of Fig. 6, according to the present invention, the capacitor $Q_{63}$ is charged up preceding the rising of the signal SBE, the transistor $Q_{64}$ in the charging circuit for the capacitor $Q_{63}$ is turned OFF so that the output terminal $V_{BS}$ is set in a floating state. Then the output voltage $V_{BS}$ is pushed up via the capacitor $Q_{63}$ by the rising of the node N26 in response to the rising of the signal SBE, and the output voltage $V_{BS}$ is increased. Thus, the circuit of Fig. 6 has an advantage in that there is no delay in operation. Since the capacitor $Q_{63}$ is used as a voltage supply for the signal SBE and is necessary by charge up parasitic capacitance accompanying the signal line SBE, the capacitance of the capacitor $Q_{63}$ should be relatively large. Because the capacitor $Q_{63}$ has been charged up through the transistor $Q_{64}$ preceding the rising of the signal SBE, the large capacitance of the capacitor $Q_{63}$ does not cause a delay in operation.

As described above, according to the present invention, the "H" level of the data output $D_{out}$ can be made equal to the level of the supply voltage $V_{cc}$, and the access time of the memory device can be decreased by speeding up the rising transition of the data output $D_{out}$.

## Claim

A semiconductor memory device comprising a higher voltage supply ($V_{cc}$); a lower voltage supply ($V_{ss}$); and a signal generator circuit (19) for delivering a signal (OBE) which is higher than the higher supply voltage ($V_{cc}$) in response to an input signal (SBE); characterised in that a voltage generator circuit (20) supplies an output voltage ($V_{BS}$) which is higher than the higher supply voltage ($V_{cc}$) as a power supply voltage to the signal generator circuit (19); and that the output stage of the signal generator circuit (19) has a first transistor (Q22) which is connected to the lower voltage suply ($V_{ss}$) and a second transistor (Q21) which is connected to the output voltage ($V_{BS}$) of the voltage generator circuit (20), the first (Q22) and second (Q21) transistors being connected in a push-pull configuration with a junction between them being connected to the output terminal (OBE) of said second generator circuit (19); and in that an output portion of the voltage generator circuit (20) has a push-up capacitor (Q63) which is connected through one of its electrodes to the output terminal (VBS) and is operable to push up the output voltage (VBS) to a potential higher than the higher voltage supply voltage (VBC), a charging transistor (Q64) which is turned ON prior to the rise in potential of the output terminal (OBE) of the signal generator circuit (19) to charge the push-up capacitor via the higher supply voltage (VCC) and is turned OFF to cut the push-up capacitor (Q63) from the higher supply voltage (VCC) when the potential of the output terminal (OBE) of the signal generator circuit (19) is raised, and a transistor (Q61) as a clock means which supplies a clock signal (N26) of the same polarity as the higher voltage supply (VCC) to the other electrode of the push-up capacitor (Q63) in response to an input signal (SBE) to raise the potential of the output terminal (OBE) of the signal generator circuit (19).

## Patentanspruch

Halbleiterspeichervorrichtung mit einer höheren Spannungsversorgung ($V_{cc}$); einer niedrigeren Spannungsversorgung ($V_{ss}$); und einer Signalgeneratorschaltung (19) zum Liefern eines Signals (OBE), das höher als die höhere Versorgungsspannung ($V_{cc}$) ist, in Abhängigkeit von einem Eingangssignal (SBE); dadurch gekennzeichnet, daß eine Spannungsgeneratorschaltung (20) eine Ausgangsspannung ($V_{BS}$), die höher als jene höhere Versorgungsspannung ($V_{cc}$) ist, als Energieversorgungsspannung an die Signalgeneratorschaltung (19) liefert, die die Ausgangsstufe der Signalgeneratorschaltung (19) einen ersten Transistor (Q22) hat, der mit der niedrigeren Spannungsversorgung ($V_{ss}$) verbunden ist, und einen zweiten Transistor (Q21), der mit der Ausgangsspannung ($V_{BS}$) der Spannungsgeneratorschaltung (20) verbunden ist, wobei der erste (Q22) und zweite (Q21) Transistor in einer Gegentakt-Konfiguration verbunden sind, mit einem Koppelpunkt zwischen ihnen, der mit dem Ausgangsanschluß (OBE) der genannten Signalgeneratorschaltung (19) verbunden ist; und daß ein Ausgangsabschnitt der Spannungsgeneratorschaltung (20) einen Push-up-Kondensator (Q63) hat, der über eine seiner Elektroden mit dem Ausgangsanschluß (VBS) verbunden und betreibbar ist, um die Ausgangsspannung (VBS) auf ein Potential hochzuschieben, das höher als die höhere Versorgungsspannung (VBC) ist, einen Ladetransistor (Q64), der vor dem Potentialanstieg des Ausgangsanschlusses (OBE) der Signalgeneratorschaltung (19) auf EIN geschaltet wird, um den Push-up-Kondensator über die höhere Versorgungsspannung ($V_{CC}$) zu laden, und auf AUS geschaltet wird, wenn das Potential des Ausgangsanschlusses (OBE) der Signalgeneratorschaltung (19) angehoben wird, um den Push-up-Kondensator (Q63) von der höheren Versorgungsspannung ($V_{CC}$) zu trennen, und einen Transistor (Q61), der eine Takteinrichtung hat, die ein Taktsignal (N26) von derselben Polarität wie die höhere Versorgungsspannung ($V_{CC}$) an die andere Elektrode des Push-up-Kondensators ($Q_{63}$ liefert, in Abhängigkeit von einem Eingangssignal (SBE), um das Potential des Ausgangsanschlusses (OBE) der Signalgeneratorschaltung (19) anzuheben.

**Revendication**

Dispositif de mémoire à semiconducteur comprenant une source de tension supérieure ($V_{CC}$); une source de tension inférieure ($V_{SS}$); et un circuit générateur de signaux (19) pour produire un signal (OBE) qui est supérieur à la tension de source supérieure ($V_{CC}$) en réponse à un signal d'entrée (SBE); caractérisé en ce qu'un circuit générateur de tension (20) fournit une tension de sortie ($V_{BS}$) qui est supérieure à la tension de source supérieure ($V_{CC}$) comme tension de source d'alimentation au circuit générateur de signaux (19); en ce que l'étage de sortie du circuit générateur de signaux (19) comporte un premier transistor ($Q_{22}$) qui est connecté à la source de tension inférieure ($V_{SS}$) et un deuxième transistor ($Q_{21}$) qui est connecté à la sortie de tension ($V_{BS}$) du circuit générateur de tension (20), le premier ($Q_{22}$) et le deuxième transistor ($Q_{21}$) étant connectés selon une configuration push-pull, une jonction enter ceux-ci étant connectée à la borne de sortie (OBE) du circuit générateur de signaux (19); et en ce qu'une partie de sortie du circuit générateur de tension (20) comporte un condensateur élévateur ($Q_{63}$) qui est connecté par une de ses électrodes à la borne de sortie ($V_{BS}$) et peut être mis en fonctionnement pour élever la tension de sortie ($V_{BS}$) jusqu'à un potentiel supérieur à la tension de source de tension supérieure ($V_{CC}$), un transistor de charge ($Q_{64}$) qui est rendu conducteur avant la montée de potentiel à la borne de sortie (OBE) du circuit générateur de signaux (19) pour charger le condensateur élévateur par la source de tension supérieure ($V_{CC}$) et qui est bloqué pour couper le condensateur élévateur ($Q_{63}$) de la source de tension supérieure ($V_{CC}$) quand le potentiel de la borne de sortie (OBE) du circuit générateur de signaux (19) est élevé, et un transistor ($Q_{61}$) comme moyen à horloge qui fournit un signal d'horloge (N26) de la même polarité que la source de tension supérieure ($V_{CC}$) à l'autre électrode du condensateur élévateur ($Q_{63}$) en réponse à un signal d'entrée (SBE) pour élever le potentiel de la borne de sortie (OBE) du circuit générateur de signaux (19).

ROW DEC 13   10   14   ROW DEC

Fig. 1

SA   CL₁

BL₁   Q₁   Q₂   BL₁

CELL   CELL   12

$\overline{BL}_n$   $BL_n$

SA   CL_n

$Q_{n1}$   $Q_{n2}$

11

$\overline{DB}$   DB

RD   16   OUT   17

15   S B   $\overline{RD}$   O B   $\overline{OUT}$   OT   ⟨Dout⟩

18   19

SBE GEN   SBE   OBE GEN   OBE

EP 0 170 781 B1

# Fig. 2

EP 0 170 781 B1

Fig. 3

# Fig. 4

# Fig. 5

# Fig. 6

# Fig. 7